(19) Europäisches Patentamt
European Patent Office
Office européen des brevets

(11) **EP 2 697 413 B1**

(12) **EUROPÄISCHE PATENTSCHRIFT**

(45) Veröffentlichungstag und Bekanntmachung des Hinweises auf die Patenterteilung:
**10.06.2015  Patentblatt 2015/24**

(51) Int Cl.:
*C30B 15/14* $^{(2006.01)}$     *C30B 28/10* $^{(2006.01)}$
*C30B 15/08* $^{(2006.01)}$

(21) Anmeldenummer: **12713636.4**

(22) Anmeldetag: **21.03.2012**

(86) Internationale Anmeldenummer:
**PCT/EP2012/054963**

(87) Internationale Veröffentlichungsnummer:
**WO 2012/139865 (18.10.2012 Gazette 2012/42)**

(54) **VERFAHREN UND VORRICHTUNG ZUR HERSTELLUNG VON MATERIAL MIT MONO- ODER MULTIKRISTALLINER STRUKTUR**

METHOD AND DEVICE FOR PRODUCING MATERIAL HAVING A MONOCRYSTALLINE OR MULTICRYSTALLINE STRUCTURE

PROCÉDÉ ET DISPOSITIF DE PRODUCTION D'UN MATÉRIAU PRÉSENTANT UNE STRUCTURE MONOCRISTALLINE OU POLYCRISTALLINE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.04.2011   DE 102011007149**

(43) Veröffentlichungstag der Anmeldung:
**19.02.2014   Patentblatt 2014/08**

(73) Patentinhaber: **Streicher Maschinenbau GmbH & Co. KG**
**94469 Deggendorf (DE)**

(72) Erfinder: **KÖCKEIS, Rupert**
**94513 Schönberg (DE)**

(74) Vertreter: **Winter, Brandl, Fürniss, Hübner, Röss, Kaiser, Polte - Partnerschaft mbB Patent- und Rechtsanwaltskanzlei Bavariaring 10 80336 München (DE)**

(56) Entgegenhaltungen:
**EP-A1- 0 634 504     DE-B- 1 204 837**
**FR-A- 1 387 497     JP-A- 62 246 894**
**US-A- 4 108 714**

EP 2 697 413 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die vorliegende Erfindung bezieht sich auf eine Vorrichtung und ein Verfahren zur Herstellung von Material mit mono- oder multikristalliner Struktur. Bevorzugt werden die erfindungsgemäße Vorrichtung und das erfindungsgemäße Verfahren zur Herstellung von monokristallinem Silizium verwendet.

Stand der Technik

Aus dem Stand der Technik sind eine Vielzahl von Herstellungsverfahren für halblei-tertaugliches Silizium, insbesondere für die Verwendung in Photozellen, bekannt. Beispiele sind das Verfahren des Aufschmelzens von mulikristallinem Silizium in einem Quarztiegel, das Czochralski-Verfahren und das Zonenziehverfahren bekannt.

Nach dem Aufschmelzen von multikristallinem Silizium in einem Quarztiegel erfolgt ein langsames Abkühlen, was qualitative Nachteile mit sich bringt. Im Ergebnis liegen zahllose kristalline Bereiche mit unterschiedlichen Größen vor, so dass das Ausgangsprodukt ein Multikristall ist. Von Vorteil ist bei diesem Aufschmelzverfahren, dass eine große Menge von Silizium, beispielsweise von 800 kg, in einem Vorgang aufgeschmolzen werden kann. Da jedoch kein Monokristall am Ende des Kristallisationsprozesses vorliegt, werden aufgrund der vielen Kristallgitterwechsel keine bevorzugten Halbleitereigenschaften des resultierenden Multikristalls erhalten.

Bei dem Czochralski-Verfahren, das auch als Tiegelziehverfahren bezeichnet wird, wird Silizium in einem Tiegel bei einer Temperatur, die geringfügig über dem Schmelzpunkt liegt, aufgeschmolzen und dann über einen monokristallinen Impfling aus der Schmelze ein Kristall über Drehen gezogen. Als Resultat ergibt sich ein Monokristall mit wesentlich besseren Kristalleigenschaften für die Verwendung bei Photozellen im Vergleich zu dem Aufschmelzen von multikristallinem Silizium in einem Quarztiegel.

Sowohl das Aufschmelzen in einem Quarztiegel als auch das Czochralski-Verfahren haben eine Vielzahl von Nachteilen:

Aufgrund der langen Verweilzeit im Quarztiegel löst sich Sauerstoff aus dem Quarztiegel in der Siliziumschmelze. Diese Sauerstoffatome bauen sich in den Kristall ein. Bei der Verwendung von Graphitheizern für den Tiegel zum Halten der Temperatur sublimieren Kohlenstoffatome in die Inertgas-Atmosphäre und lösen sich in der Schmelze. Auch hier erfolgt ein Einbau von diesen in den Kristall. Es ergibt sich eine negative Beeinflussung der Halbleitereigenschaften, wodurch sich die Lebensdauer von freien Elektronen gravierend verringert, so dass sich eine Verringerung des Wirkungsgrades einer Photozelle, die auf der Basis dieses Materials hergestellt wird, ergibt.

Die qualitativen Nachteile des Aufschmelzverfahrens und des Czochralski-Verfahrens werden beim Zonenziehverfahren beseitigt. Das Zonenziehverfahren wird auch als Float-Zone-Verfahren bezeichnet.

Beim Zonenziehverfahren erfolgt eine Erwärmung über Induktionsheizung. Genauer gesagt wird ein multikristalliner Siliziumstab an einer Induktionsspule entlang geführt. Der Siliziumstab wird von unten nach oben in ein Monokristall umgeschmolzen. Der resultierende Monokristall hat eine hohe Reinheit. Die Vorteile des Zonenziehverfahrens bestehen darin, dass sich im Gegensatz zum Czochralski-Verfahren und Aufschmelzverfahren keine negativen Materialeigenschaften bezüglich der Elektronenlebensdauer ergeben. Darüber hinaus ist der benötigte Energieeinsatz geringer, weil nur eine begrenzte Zone von Silizium aufgeschmolzen wird und sich dadurch wesentlich geringere Abstrahlverluste ergeben.

Der Nachteil beim Zonenziehverfahren besteht darin, dass als Ausgangsmaterial polykristalline Stäbe von hoher Güte notwendig sind. So werden beim Zonenziehverfahren bezüglich der geometrischen Form und der Rissfreiheit hohe Anforderungen an die Polystäbe gestellt. Die Produktion dieser hochqualitativen Polystäbe ist nur mit großem Zeitaufwand möglich, woraus sich hohe Herstellkosten ergeben.

In der Offenlegungsschrift DE 42 165 19 A1 wird versucht, die Vorteile des Zonenziehverfahrens mit den Vorteilen eines Prozesses zum günstigen Herstellen von Multi-Silizium zu verbinden. Genauer gesagt wird granulares Silizium von oben in eine wieder verwendbare Silizium-Röhre eingeführt. Dieses Silizium gelangt in die Schmelzzone, die die Silizium-Röhre abschließt und in der die Erwärmung über Induktionsheizung erfolgt.

Der Nachteil bei dem Verfahren entsprechend der DE 42 165 19 A1 besteht darin, dass hohe Anforderungen an eine homogene Materialbeschaffenheit und eine äußerst kontrollierte Materialnachführung bestehen. Mit dieser Materialnachführung soll ein unkontrolliertes Entweichen der Schmelze verhindert und der sich anschließende mögliche Abbruch des gesamten Umschmelzvorgangs verhindert werden.

In der Offenlegungsschrift EP 0 634 504 A1 wird ein Verfahren zu Herstellung eines Siliziumkristalls beschrieben. Ein Impfkristall befindet sich unter einer festen Phase des Kristalls und darüber befindet sich eine geschmolzene Phase. Eine freie Oberfläche der geschmolzenen Phase begrenzt eine Schmelzkammer, in welcher die freie Oberfläche der geschmolzenen Phase mittels einer Elektronenstrahlquelle geheizt wird. Der Kristall wächst, während der Impfkristall unter Drehung abgesenkt wird und weiteres Granulat in die freie Oberfläche der geschmolzenen Phase chargiert wird, wo das Granulat schmilzt. Die freie Oberfläche wird dabei auf demselben Niveau gehalten.

In der JP 62 246894 A wird eine Vorrichtung zum Herstellen eines Einkristalls vorgestellt, bei welcher ein Tiegel über einem Impfkristall angeordnet ist. In den Tiegel wird polykristallines Granulat eingegeben und geschmolzen. Der Impfkristall befindet sich unter einem Auslass des Tiegels, welcher mit einem Kegel verschließbar ist. Die Höhe der Schmelze hängt somit von dem um den Kegel verbleibenden Ringraum ab. Der Kristall wächst, während der Impfkristall unter Drehung abgesenkt wird.

In der DE 12 04 837 B wird eine Vorrichtung zum kontinuierlichen Herstellen von Stäben aus thermoelektrischen Werkstoffen, wie Wismut und Tellur, beschrieben. Oben in der Vorrichtung befindet sich eine von einem Schmelzofen umgebene Vorratszone, welche mit Werkstoff beschickt wird. An diese schließen sich in senkrechter Richtung nacheinander eine von einem weiteren Schmelzofen umgebene und flüssiges Material enthaltende Zone, eine von einem Isolator umgebene und eine Feststoff-Flüssigkeits-Grenzfläche enthaltende Zone, eine von einem gekühlten Mantel umgebene und Feststoff enthaltende Zone sowie eine Bodenöffnung an. Durch die Bodenöffnung wird der gegossene Werkstoff mittels eines Impfstabs abgezogen. Um das Abziehen zu erleichtern, wird die Vorratszone mit einem Überdruck eines Gases beaufschlagt.

Bei einer Vorrichtung zum Herstellen Plattenförmiger Siliziumkörper nach der US 4 108 714 A wird eine Siliziumschmelze in einem Tiegel erwärmt, durch eine schlitzartige Öffnung ausgegeben und mittels eines Paares an Walzen bandförmig gewalzt. Dabei kann der Tiegel gasdicht verschlossen und mittels eines Gases mit einem Überdruck beaufschlagt sein, um die Schmelze durch die schlitzartige Öffnung kontrolliert herauszudrücken.

Die FR 1 387 497 A beschreibt eine Vorrichtung zum Stranggießen eines thermoelektrischen Materials. Die Vorrichtung umfasst von oben nach unten einen Ofen mit Heizelementen zum Schmelzen des Materials, eine Matrize zum Herausziehen geschmolzener Ladung, einen Kühltank mit einem inerten Kühlmedium und eine untere Öffnung, durch welche ein gegossener Strang aus dem Kühltank herausgezogen wird. Durch ein Gaseinlassrohr wird ein inertes Gas in den Ofen eingeleitet, um die geschmolzene Ladung durch die Matrize zu schieben.

Kurzdarstellung von Aspekten der Erfindung

Aufgabe der vorliegenden Erfindung ist es, eine Vorrichtung und ein Verfahren zur Herstellung von Material mit mono- oder multikristalliner Struktur vorzusehen, bei denen die Nachteile des Standes der Technik beseitigt sind. Insbesondere sollen mono- oder multikristalline Materialien mit hoher Qualität hergestellt werden.

Darüber hinaus soll mit der Erfindung eine Robustheit gegenüber Schwankungen in der Zuförderung erzielt werden und es soll bevorzugt die Möglichkeit geschaffen werden, Ausgangsmaterial kontinuierlich zuzuführen. Bei besonderen Ausgestaltungen der Erfindung sollen monokristalline Siliziumstäbe ohne den Einsatz von aufwendig hergestellten Polysiliziumstäben hergestellt werden. Durch das Verwenden von partikelförmigen, günstig herstellbaren Polysiliziumteilen sollen bevorzugt die Nachteile des teueren Einsatzes von polykristallinen Stäben vermieden werden.

Diese Aufgabe wird durch ein Verfahren nach Anspruch 1 und eine Vorrichtung nach Anspruch 4 gelöst.

Erfindungsgemäße Weiterbildungen sind in den Unteransprüchen enthalten.

Würdigung der Ansprüche

Entsprechend dem ersten Aspekt der vorliegenden Erfindung wird ein Verfahren zur Herstellung von Material mit mono- oder multikristalliner Struktur mit den Schritten vorgesehen:

- Einbringen eines teilchenförmigen Materialgemischs in einen Einlass eines Behältnisses,
- Erwärmen des Materialgemischs in einer Schmelzzone des Behältnisses und
- statisches Stützen des Materialgemischs in der Schmelzzone über eine Druckdifferenz zwischen dem Einlass und einem Auslass des Behältnisses.

Auf diese Weise lässt sich ein kontinuierliches Schmelzen von Materialien umsetzen. Vorteilhaft ist auch die Möglichkeit der Verwendung von Materialien mit granularer Ausgangsbasis.

Bei dem erfindungsgemäßen Verfahren entsprechend dem vorstehenden ersten Aspekt wird entsprechend einem zweiten Aspekt bevorzugt, dass das statische Stützen zwischen zwei Kammern erfolgt, die durch das Behältnis getrennt sind und zwischen denen die Druckdifferenz vorliegt. Vorteilhaft an dieser Ausgestaltung ist, dass entweder jede der Kammern vom Druck her getrennt geregelt wird oder diese Kammern durch eine Druckdifferenzregelung miteinander verbunden sind. Im Ergebnis kann mit geringem vorrichtungstechnischen Aufwand die Druckdifferenz umgesetzt werden.

Entsprechend einer Ausgestaltung des dritten Aspekts des erfindungsgemäßen Verfahrens kann jeder der vorliegenden Aspekte dadurch fortgebildet sein, dass ein Kontaktieren des Materialgemischs, vorzugsweise in der Schmelzzone, mit einem Impfkristall am oder benachbart zum Auslass des Behältnisses erfolgt. Im Ergebnis können bei der Materialherstellung die Vorteile des Zonenziehverfahrens erreicht werden. Ferner lassen sich so auch die Zone zum Aufschmelzen und die zum Ziehen des Kristalls trennen, was ein erhöhtes Volumen des Behälters, aus dem gezogen wird, ermöglicht, wenn dieser kein Durchlaufbehälter ist.

Entsprechend einem vierten Aspekt kann bei einem der vorstehenden der drei Aspekte ein Abziehen des Impfkristalls bzw. Impflings aus der Schmelzzone zum Ausbilden eines monokristallinen halbleitenden Siliziumstabes erfolgen. Somit ist Silizium mit hoher Reinheit mit geringem vorrichtungstechnischen Aufwand erhaltbar.

Entsprechend einem fünften Aspekt, das einen der ersten bis dritten Aspekte weiterbildet, ist das Material ein halbleitendes Material, ein Verbindungshalbleiter und/oder eine Metalllegierung. Im Ergebnis ist mit geringem vorrichtungstechnischen Aufwand ein kontinuierliches Vorsehen von aufgeschmolzenem Material möglich.

Entsprechend einem sechsten Aspekt, das den vierten Aspekt weiterbildet, kann das teilchenförmige Materialgemisch teilchenförmiges Silizium aufweisen und kann das erzeugte, halbleitende Material multikristallines Silizium sein. Auf diese Weise kann statt des herkömmlichen Zonenziehverfahrens das Verfahren mit dem Differenzdruckabstützen in effizienter Weise ersetzt werden.

Der siebente Aspekt der vorliegenden Erfindung, der den vierten Aspekt weiterbildet, kann ein teilchenförmiges Materialgemisch in Form von teichenförmigem Silizium aufweisen. Ferner ist bei diesem das erzeugte halbleitende Material monokristallines Silizium, das entsprechend einem achten Aspekt bevorzugt die Form eines Siliziumstabes hat. Somit ist der Ersatz des herkömmlichen Zonenziehverfahrens möglich.

Bei dem Verfahren entsprechend einem der vorliegenden acht Aspekte kann entsprechend einem neunten Aspekt das Einstellen des Differenzdrucks über eine Differenzdruckregelung erfolgen. Somit ist es mit geringem vorrichtungstechnischen Aufwand möglich, die Höhe der Schmelze im Behältnis auf einem bestimmten Wert zu halten.

Als Alternative zum neunten Aspekt kann einer der vorstehenden ersten bis achten Aspekte entsprechend einem zehnten Aspekt dadurch weitergebildet sein, dass der Differenzdruck über zwei Absolutdruckregler eingestellt wird. Der Vorteil ist hier, eine vollständige Entkopplung der Druckbereiche an beiden Seiten des Behältnisses.

Entsprechend einem elften Aspekt kann einer der ersten bis zehnten Aspekte dadurch weitergebildet sein, dass das Volumen des Materials im Behälter über eine Höhenmessung gemessen wird. Im Ergebnis kann die Niveaubestimmung im Schmelztiegel in Verbindung mit einem kegelartigen Tiegel über eine Durchmesserbestimmung erfolgen.

Eine Vorrichtung entsprechend der vorliegenden Erfindung kann entsprechend einem zwölften Aspekt der Erfindung zur Herstellung von Material mit mono- oder multikristalliner Struktur ausgebildet sein und aufweisen: ein Behältnis, das einen Einlass hat, über den ein teilchenförmiges Materialgemisch einbringbar ist, eine Erwärmungseinrichtung, mit der das Materialgemisch in einer Schmelzzone des Behältnisses erwärmbar ist, und eine Druckerzeugungseinrichtung zum Erzeugen einer Druckdifferenz zwischen dem Einlass und dem Auslass des Behältnisses, über die das Materialgemisch in der Schmelzzone statisch stützbar ist. Im Ergebnis lässt sich mit geringem vorrichtungstechnischen Aufwand die Höhe der Schmelze im Behältnis einstellen. Darüber hinaus kann eine Struktur des erzeugten Materials mit hoher Reinheit hergestellt werden.

Die Vorrichtung entsprechend dem zwölften Aspekt kann dadurch weitergebildet sein, dass zwei Kammern vorgesehen sind, die durch das Behältnis getrennt sind, und zwischen denen die Druckdifferenz vorliegt. Damit ist mit geringem vorrichtungstechnischen Aufwand eine kontinuierliche Materialerzeugung mit hoher Reinheit möglich.

Die Vorrichtung entsprechend dem zwölften und dreizehnten Aspekt kann entsprechend einem vierzehnten Aspekt dadurch weitergebildet sein, dass eine Differenzdruckregeleinrichtung vorgesehen ist, über die der Differenzdruck zwischen den zwei Kammern regelbar ist. Im Ergebnis ist eine Differenzdruckregelung zur Einstellung eines Differenzdrucks zwischen zwei Vakuumbehältnissen möglich. Der steuerungstechnische Aufwand dazu ist gering.

Als Alternative zur Differenzdruckregelung entsprechend dem vierzehnten Aspekt können bei einem fünfzehnten Aspekt, der die Vorrichtung nach dem zwölften und dreizehnten Aspekt weiterbildet, zwei Absolutdruckregeleinrichtungen vorgesehen sein, die einer jeweiligen Kammer zugeordnet sind, und über die der Differenzdruck zwischen den zwei Kammern regelbar ist. Durch die zwei Absolutdruckregeleinrichtungen ist es möglich, zwei vollkommen getrennte Kammern vorzusehen, über die die vorteilhafte Einstellung der Höhe des Pegels in der Schmelzzone im Behältnis möglich ist.

Bei einer Vorrichtung entsprechend einem der zwölften bis fünfzehnten Aspekte kann ein Impfkristall bzw. Impfling vorgesehen sein, über den das Materialgemisch, vorzugsweise in der Schmelzzone, an oder benachbart zu einem Auslass des Behältnisses kontaktierbar ist und über den das halbleitende Material aus der Schmelzzone abziehbar ist. Somit lässt sich beim Zonenziehverfahren in einfacher Weise ein kontinuierlicher Materialfluss herstellen und ebenfalls beispielsweise zur Ausbildung von monokristallinem Silizium einsetzen. Ferner lassen sich so auch die Zone zum Aufschmelzen und die zum Ziehen des Kristalls trennen, was ein erhöhtes Volumen des Behälters, aus dem gezogen wird, ermöglicht, wenn dieser kein Durchlaufbehälter ist.

Entsprechend einem sechzehnten Aspekt, der einen der zwölften bis fünfzehnten Aspekte weiterbildet, ist das Material ein halbleitendes Material, ein Verbindungshalbleiter und/oder eine Metalllegierung. Somit lässt sich ein reines Ausgangsprodukt bei unterschiedlichen Materialien mit einer einfachen vorrichtungstechnischen Ausgestaltung umsetzen.

Bei einer Vorrichtung entsprechend dem achtzehnten Aspekt der Erfindung, der eine Vorrichtung entsprechend dem zwölften bis sechzehnten Aspekt weiterbildet, ist das teilchenförmige Materialgemisch teilchenförmiges Silizium und ist das erzeugte halbleitende Material multikristallines Silizium. Auf diese Weise lässt sich Material mit hoher Ausgabegeschwindigkeit und Homogenität kontinuierlich erzeugen.

Als Alternative zum achtzehnten Aspekt weist bei einem neunzehnten Aspekt, durch den die Vorrichtung nach einem der Aspekte zwölfter bis siebzehnter Aspekt weitergebildet wird, das teilchenförmige Materialgemisch teilchenförmiges Silizium auf und ist das erzeugte halbleitende Material monokristallines Silizium. Auf diese Weise lässt sich mit geringem vorrichtungstechnischen Aufwand monokristallines Silizium mit hoher Reinheit kontinuierlich erzeugen.

Dabei wird entsprechend einem zwanzigsten Aspekt bevorzugt, dass das monokristalline halbleitende Material des neunzehnten Aspektes ein Siliziumstab ist. Somit lässt sich die erfindungsgemäße Vorrichtung statt der entsprechenden Vorrichtung beim Zonenziehverfahren vorteilhaft einsetzen.

Entsprechend einem einundzwanzigsten Aspekt ist die Vorrichtung von einem zwölften bis zwanzigsten Aspektes mit einer Drosseleinrichtung weitergebildet, die so dimensioniert ist, einen maximalen Differenzdruck zwischen den Kammern festlegbar ist. Auf diese Weise lässt sich ein Überlaufen der Schmelze im Behältnis verhindern.

Die Vorrichtung entsprechend dem einundzwanzigsten Aspekt kann entsprechend einem zweiundzwanzigsten Aspekt so weitergebildet sein, dass diese ein Differenzdruckregelventil aufweist, das zu der Drosseleinrichtung parallel geschaltet ist, und über das der Differenzdruck zwischen den Kammern verringerbar ist. Auf diese Weise lässt sich stärker an den konkreten Prozessverlauf angepasst die Höhe der Schmelze im Behältnis einstellen.

Entsprechend einem dreiundzwanzigsten Aspekt, der einen der zwölf bis zweiundzwanzigsten Aspekte weiterbildet, weist das teilchenförmige Silizium Siliziumpartikel mit einer Kantenlänge von maximal 20 mm, stärker bevorzugt von kleiner als 10 mm und am Stärksten bevorzugt von kleiner bzw. gleich 5 mm auf. Somit kann grober Siliziumbruch zur Erzeugung von monokristallinem Silizium mit geringem vorrichtungstechnischen Aufwand und zum Erzielen einer hohen Reinheit eingesetzt werden.

Entsprechend einem vierundzwanzigsten Aspekt, der einen der Aspekte zwölfter bis dreiundzwanzigster Aspekt weiterbildet, ist das Behältnis kegelförmig ausgebildet, wodurch ein gutes Nachfließen der Schmelze zum Austritt des Behältnisses hin sichergestellt wird. Darüber hinaus kann die Höhenmessung im Behältnis in einfacher Weise ausgeführt werden.

Entsprechend einem fünfundzwanzigsten Aspekt, erfolgt die Messung des Volumens des Materials im Behältnis über eine Höhenmessung. Dadurch wird einer der zwölften bis vierundzwanzigsten Aspekte weitergebildet. Im Ergebnis kann der Messaufwand für das Volumen der Schmelze verringert werden.

Bei einem der zwölften bis fünfundzwanzigsten Aspekte kann das Fassungsvermögen des Behältnisses maximal 1 dm$^3$ betragen. Durch eine gute Höhenniveauregulierung entsprechend der Ausgestaltung der vorliegenden Erfindung ist somit ein kleines Volumen nur notwendig, um trotzdem einen kontinuierlichen Fluss aus der Schmelzzone mit hoher Genauigkeit sicherzustellen. Im Ergebnis können Einwirkungen des Materials des Schmelztiegels oder aus der Umgebung der Druckbereiche am Behälter verringert werden.

Für das Material des Behältnisses wird entsprechend einem siebenundzwanzigsten Aspekt, der einen der zwölften bis sechsundzwanzigsten Aspekte weiterbildet, ein Material bevorzugt, dass gegenüber einer Temperatur von bis zu 1430 °C beständig ist. Auf diese Weise wird die Wechselwirkung zwischen der Schmelze im Behältnis und dem Behältnismaterial minimiert.

Entsprechend einem achtundzwanzigsten Aspekt, der einen der zwölften bis siebenundzwanzigsten Aspekte weiterbildet, weist das Behältnis eine Beschichtung auf, die bevorzugt Siliziumcarbid oder Siliziumnitrid aufweist. Durch eine derartige Beschichtung kann die Wechselwirkung zwischen Behältnis und Material in der Schmelzzone weiter verringert werden.

Entsprechend einem neunundzwanzigsten Aspekt, der einen der zwölften bis achtundzwanzigsten Aspekte weiterbildet, erfolgt die Messung des Volumen des Materials im Behältnis über eine Durchmessermessung des Materials im Behältnis. Auf diese Weise kann eine Bildaufnahmeeinrichtung zur Volumenmessung eingesetzt werden, bei der über den Durchmesser vermittels der kegelartigen Innenfläche des Behältnisses auf das Volumen geschlossen werden kann.

Entsprechend einem dreißigsten Aspekt, der einen der zwölften bis neunundzwanzigsten Aspekte weiterbildet, weist die Vorrichtung eine Differenzdruckregeleinrichtung (62), über die der Differenzdruck zwischen den zwei Kammern steuer- bzw. regelbar ist, und vorzugsweise eine Differenzdrucksteuereinrichtung, die die zwei Kammern verbindet und über die der Differenzdruck zwischen den zwei Kammern steuer- bzw. regelbar ist, auf. Auf diese Weise kann der Differenzdruck in einfacher Weise eingestellt werden.

Nachfolgend wird die Erfindung anhand bevorzugter Ausführungsbeispiele unter Bezugnahme auf die Zeichnungen beschrieben, in der

Figur 1      eine schematische Ansicht von Elementen einer Vorrichtung zur Materialherstellung entsprechend dem ersten Ausführungsbeispiel zeigt,

Figur 2A      einen Ausschnitt A aus Figur 1 entsprechend dem ersten Ausführungsbeispiel zeigt,

Figur 2B      eine Abwandlung für den Ausschnitt A aus Figur 1 entsprechend dem ersten Ausführungsbeispiel zeigt,

Figur 3      eine schematische Darstellung einer Vorrichtung zur Materialherstellung entsprechend dem zweiten Ausführungsbeispiel zeigt,

Figur 4 eine schematische Ansicht von Elementen einer Vorrichtung zur Materialherstellung entsprechend dem dritten Ausführungsbeispiel zeigt,

Figur 5 eine schematische Ansicht von Elementen einer Vorrichtung zur Materialherstellung entsprechend dem vierten Ausführungsbeispiel zeigt, und

Figur 6 eine schematische Ansicht von Elementen einer Vorrichtung zur Materialherstellung entsprechend dem fünften Ausführungsbeispiel zeigt.

Detaillierte Beschreibung der Erfindung

Nachfolgend werden Vorrichtungen und Verfahren zur Herstellung von Material vorzugsweise mit mono- oder multikristalliner Struktur unter Bezugnahme auf drei Ausführungsbeispiele und Abwandlungen dazu detaillierter beschrieben.

Die vorliegende Erfindung ist nicht nur zur Herstellung von Halbleitermaterialien, wie Germanium und Silizium, anwendbar, sondern ebenfalls auf die Herstellung von Verbindungshalbleitern, wie Indiumphosphid und Galliumarsenid, sowie auch auf die Herstellung von Kristallen, von Metallen und Legierungen von diesen. Der Einfachheit halber wird nachfolgend bei der Beschreibung der Ausführungsbeispiele auf die Herstellung von monokristallinem Silizium Bezug genommen. Diese ist jedoch in keiner Weise einschränkend auszulegen und die Erfindung ist ebenfalls zur Herstellung anderer vorstehend beispielhaft beschriebener Materialien anwendbar.

Bevorzugt soll mit dem erfindungsgemäßen Verfahren monokristallines, hochreines Halbleitersilizium hergestellt werden, das bevorzugt in der Mikroelektronik und der Fotovoltaik zum Einsatz gelangt. Für derartige Anforderungen müssen Verunreinigungen mit Elementen, die als Dotierelemente im Silizium geeignet sind, unterhalb kritischer Werte gebracht werden.

Mit der vorliegenden Erfindung soll bevorzugt die Verwendung von Siliziumpartikeln möglich sein. Diese weisen eine grobkörnige und unregelmäßige Granularität auf. Auch soll es mit dem erfindungsgemäßen Verfahren möglich sein, Silizium mit einer Oberfläche, die siliziumbruchartige Eigenschaften hat, anzuwenden. Insbesondere ist es vorteilhaft, Bruchstücke mit einer Kantenlänge von bis zu 20 mm, stärker bevorzugt von bis zu 10 mm und am stärksten bevorzugt mit einer Korngröße von bis zu 5 mm zu verwenden.

Die vorliegende Erfindung gelangt beim Herstellungsprozess in der Anwendung aus Silizium nach dem Abscheiden von polykristallinem Reinstsilizium zum Einsatz und kann bevorzugt angewendet werden, um monokristallines Silizium zu erzeugen.

Mit der vorliegenden Erfindung wird das Zonenziehverfahren weiter gebildet, bei dem sich herkömmlicher Weise Fremdatome am Ende der Siliziumsäule ablagern und diese Fremdatome nach dem Erkalten entfernt werden.

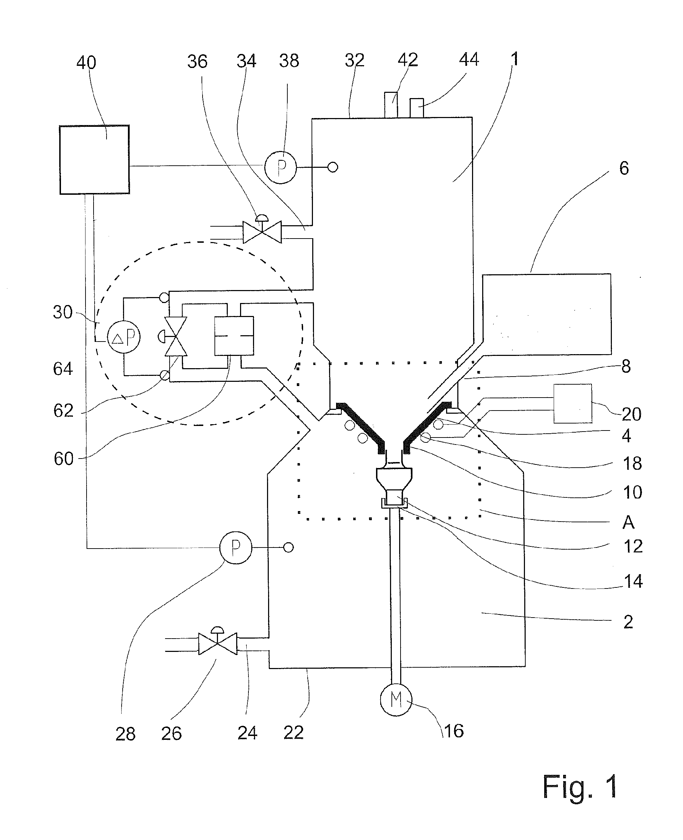

Im Unterschied zum herkömmlichen Zonenziehverfahren gelangen bei der vorliegenden Erfindung zwei Druckbereiche, vorzugsweise Überdruckbereiche, 1 und 2 zum Einsatz, die durch einen Tiegel 4 voneinander getrennt sind, wie es in Figur 1 gezeigt ist. Aufgrund von unterschiedlichen Drücken in den Druckbereichen 1 und 2 erfolgt ein statisches Stützen einer flüssigen Schmelze des Ausgangsmaterials der Erfindung über dem in diesem Beispiel als Tiegel 4 ausgestalteten Behältnis.

Teilchenförmiges Silizium gelangt aus einem Vorratsbehälter 6 über eine Fördereinrichtung 8 in den Tiegel 4, in dem das Silizium aufgeschmolzen wird. Aus dem Tiegel 4 fließt das Silizium über einen Austritt heraus und wird an einem Impfling 12 als monokristallines Silizium angeschmolzen. Das teilchenförmige Silizium kann beispielsweise eine granulare, rundkornartige Beschaffenheit haben oder Siliziumbruch sein.

Der Impfling 12 befindet sich an einem Impflinghalter 14 und wird über diesen in Rotation versetzt bzw. nach unten gezogen. Beim Ziehen des Impflings 12 erfolgt ein kontinuierliches Ersetzen von dem den Tiegel 4 als Schmelzfluss verlassenden Silizium über die Fördereinrichtung 8 aus dem Vorratsbehälter 6.

Der Tiegel 4 hat die Funktion eines dynamischen Puffers, über den ein möglichst konstanter Schmelzfluss in Richtung des monokristallinen Impflings 12 ermöglicht wird. Auf diese Weise wird eine Entkopplung von Störgrößen auf der Förderseite umgesetzt.

An dem Tiegel 4 erfolgt eine druckmäßige Entkopplung zwischen der Oberseite des Tiegels, das heißt der Befüllseite, im Druckbereich 1 von der Unterseite des Tiegels im Druckbereich 2, in dem das geschmolzene Silizium den Tiegel verlässt. Im Ergebnis stellt sich eine Druckdifferenz zwischen dem Druckbereich 1 und dem Druckbereich 2 über den Tiegel ein. Diese Druckdifferenz hat die Funktion, eine definierte Menge an geschmolzenem Silizium im Tiegel 4 zu bevorraten und auf diese Weise einen dynamischen Puffer zu bilden.

Der Impflinghalter 14 wird über ein Antriebssystem 16 in Rotation versetzt.

Die Erwärmung des Tiegels 4 erfolgt bevorzugt über eine Induktionsspule 18, die über einen Induktionsgenerator 20 versorgt wird.

Der Druckbereich 2 befindet sich in einem unteren Druckbehälter 22 mit einem Einlass 24, über den über ein Steuerventil 26 die Fluidzuführung erfolgt.

Bei der vorliegenden Erfindung wird als Fluid bevorzugt ein Inertgas wie zum Beispiel Argongas verwendet. Es kann jedoch ein beliebiges anderes Fluid eingesetzt werden, mit dem über dem Tiegel 4 eine Druckdifferenz aufrecht erhalten werden kann. Es wird bevorzugt, wenn das Fluid mit dem herzustellenden Material gar nicht, oder zumindest nur geringfügig in Wechselwirkung tritt. Nachfolgend wird sich auf das Fluid der Einfachheit halber als ein Inertgas bezogen.

Der Druck des Inertgases im Druckbereich 2 wird über eine Druckmesseinrichtung 28 gemessen. Der Druckbereich 2 und der obere Druckbereich 1 stehen über ein weiter unten beschriebenes Verbindungssystem 30 miteinander in Fluidverbindung. Der Druckbereich 1 ist in einem oberen Druckbehälter 32 definiert, der einen Auslass 34 aufweist. Der Druck am Auslass ist durch ein Steuerventil 36 einstellbar. Eine Druckmesseinrichtung 38 misst den Druck im oberen Druckbereich 1. In Figur 1 sind die Druckmesseinrichtung 28, 30 und 38 als mit einer Steuereinrichtung 40 verbunden gezeigt. Es wird bevorzugt, wenn auch die Steuerventile 26 und/oder 36 sowie die Steuereinrichtungen im Verbindungssystem 30 über die Steuereinrichtung 40 angesteuert werden bzw. Signale in diese liefern.

In den oberen Druckbereich 1 weisend sind ein Höhensignalsensor 42 zum Aufnehmen eines Höhensignals für den Stand der Schmelze im Tiegel 4 und ein Temperatursignalsensor 44 zum Messen der Temperatur der Schmelze im Tiegel 4 vorgesehen. Der Höhensignalsensor 42 ist bevorzugt eine Bildaufnahmeeinrichtung, über die ein Messsignal entnehmbar ist, das Rückschlüsse auf die Höhe des Pegels der Schmelze im Tiegel 4 zulässt. Der Temperatursignalsensor 44 ist bevorzugt ein Pyrometer.

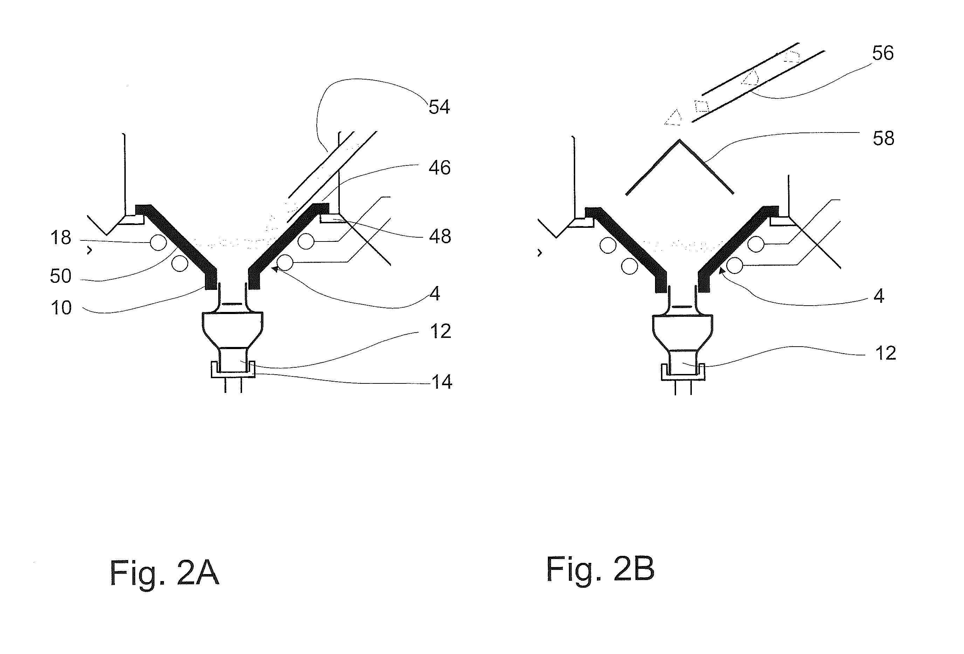

In Figur 2A ist der Bereich um den Tiegel 4 aus Figur 1 entsprechend dem ersten Ausführungsbeispiel vergrößert dargestellt. Der Tiegel 4 ist als Durchlauftiegel ausgebildet und weist einen Flanschabschnitt 46 auf, über den eine fluiddichte, vorzugsweise gasdichte, Verbindung mit einer Trenneinrichtung 48 vorsehbar ist, die den oberen Druckbereich 1 und den unteren Druckbereich 2 trennt. Die Trenneinrichtung 48 wird gekühlt, damit eine effektive Abdichtung zwischen dem Tiegel und der Trenneinrichtung 48 möglich ist. Der Tiegel läuft ausgehend von Flanschabschnitt 46 kegelförmig zum Austritt 10 hin zu. Der Austritt 10 in Form einer Öffnung ist rechtwinklig zur Längsachse des Impflings 12 angeordnet. Der Durchmesser des Austritts kann beispielsweise ein bis zwei Zentimeter betragen, kann jedoch auch in Abhängigkeit vom Prozess größer ausgestaltet sein. Über den Austritt 10 verlässt das geschmolzene Silizium den Tiegel. Durch die Verwendung eines Durchlauftiegels als Tiegel 4 ist es möglich, teilchenförmiges Silizium mit nicht nur granularer, rundkornartiger Beschaffenheit, sondern auch mit Merkmalen eines Siliziumbruches zu verwenden.

Nachfolgend werden weitere Angaben zu den Materialeigenschaften und den geometrischen Fertigungstoleranzen in Bezug auf den Tiegel gemacht. Das Tiegelmaterial muss der Schmelztemperatur von dem einzubringenden Material, im vorliegenden Ausführungsbeispiel Silizium, standhalten. Das heißt für den Anwendungsfall auf Silizium muss einer Schmelztemperatur von 1430 °C standgehalten werden. Durch das Tiegelmaterial bedingt soll die Diffusion von Fremdatomen in die Siliziumschmelze minimiert werden was hohe Anforderungen an die Reinheit des Materials des Tiegels stellt und ebenfalls Auswirkungen auf eine mögliche Tiegelbeschichtung hat. Beispielsweise wird als Material für den Tiegel Quarz in Form von Fumed Silica verwendet und es gelangt eine Tiegelbeschichtung zum Einsatz. Diese ist beispielsweise Siliziumcarbid mit einer Dicke von 0,2 bis 0,3 mm, die bevorzugt durch ein PVD(physical vapor deposition)-Abscheideverfahren aufgebracht wird. Alternativ ist beispielsweise auch Siliziumnitrid für die Tiegelbeschichtung einsetzbar.

Das Fassungsvolumen des kegelförmigen Tiegelabschnitts 50 beträgt bis zu 1 dm$^3$, kann jedoch auch oberhalb dieses Wertes liegen. Es wird bevorzugt, wenn ein möglichst kleines Tiegelvolumen vorliegt. Die Auslegung des Tiegelvolumens erfolgt in Abhängigkeit von der Aufschmelzzeit der Siliziumpartikel, die wiederum von der Partikelgröße abhängt. Die Aufschmelzzeit ist größer, je größer die zugeführten Siliziumpartikel sind.

Bei dem Tiegel besteht ferner die Anforderung, dass die Verweilzeit der Schmelze im Tiegel gering gehalten wird, damit die Kontamination aufgrund der Diffusion von Fremdatomen, zum Beispiel Sauerstoff, aus der Tiegelwand durch die Tiegelbeschichtung hindurch in die Schmelze minimiert wird. Für die erfindungsgemäße Vorrichtung ist es zu bevorzugen, dass Schwankungen in der Partikelzuführung die Kontinuität des Schmelzflusses nicht beeinflussen. Für den Fall, dass eine Ziehgeschwindigkeit von 2 mm je Minute angenommen wird, was einem Schmelzfluss von 0,04 dm$^3$ je Minute bei einem Siliziumkristall mit einem Durchmesser von 150 mm entspricht, entspricht die Verweilzeit im Tiegel bei einem Tiegelvolumen von 1 dm$^3$ im Durchschnitt 25 Minuten.

Außerhalb des Tiegels 4 und diesen im kegelförmigen Tiegelabschnitt 50 im Wesentlichen ringförmig umgebend ist die Induktionsspule 18 angeordnet, die über die Erwärmungseinrichtung 20 in Form eines Induktionsgenerators gespeist wird. Diese Induktionsspule 18 dient zum Aufschmelzen der Siliziumpartikel.

Für den Beginn des Prozesses der Materialherstellung ist es notwendig, das Silizium beispielsweise auf ca. 600 °C, beispielsweise per Strahlungsheizung, zu erwärmen. Diese kann entweder oberhalb des Tiegels 4 oder unterhalb des Tiegels 4 angeordnet sein.

Der Temperatursignalsensor 44 in Form des Pyrometers erfasst die Schmelztemperatur und ist bevorzugt am oberen Druckbehälter 32 angebracht.

Die Bildaufnahmeeinrichtung 42, über deren Messsignal die Pegelhöhe der Siliziumschmelze im Tiegel 4 erfassbar ist, erfasst den Durchmesser der Siliziumschmelze. Dieser Bildaufnahmeeinrichtung 42 nachgeschaltet ist eine nicht dargestellte Bildauswerteeinrichtung, über die der Durchmesser der Siliziumschmelze in rechnerischer Form Rückschlüsse auf die Schmelzhöhe zulässt. Die Bildaufnahmeeinrichtung 42 und die Bildauswerteeinrichtung sind bevorzugt mit der Steuereinrichtung 40 gekoppelt, um nach einer Schmelzhöhenmessung eine Einstellung der Zufördermenge über die Fördereinrichtung 8 vornehmen zu können. Über die Einstellung der Zufördermenge lässt sich eine Regelung zum Konstanthalten des Schmelzniveaus im Tiegel 4 umsetzen. Mit einer derartigen Regelung ist es entsprechend der vorliegenden Erfindung möglich, Siliziumpartikel auch oberhalb der im Dokument DE 42 165 19 A1 verwendeten Partikel von bis zu 1 mm umzusetzen.

Für eine bevorzugte Einstellung der Zufördermenge ist der Vorratsbehälter 6 benachbart zum Druckbereich 1, das heißt oberhalb des Tiegels 4, positioniert. Der Vorratsbehälter 6 steht über eine Zuführleitung mit der Fördereinrichtung 8 mit dem Tiegel 4 in Verbindung. In dem Vorratsbehälter 6 befinden sich bevorzugt polykristalline Siliziumpartikel und der Vorratsbehälter 6 sowie die Fördereinrichtung 8 sind bevorzugt dem Druckbereich 1, das heißt dem Raum oberhalb des Tiegels 4, zugeordnet. Somit liegt der Druck im Vorratsbehälter 6 auf dem gleichen Druck $P_{oben}$ wie der Druck im Druckbereich 1.

Der Impfling 12 am Austritt 10 des Tiegels 4 weist bevorzugt Impfkristalle auf, die unter Laborbedingungen erzeugte Einkristalle mit der gleichen Kristallorientierung wie der gewünschte gezüchtete Kristall am Austritt 10 sind.

Es ist vorteilhaft, wenn der Innendurchmesser des Tiegels am Austritt 10 größer als der Außendurchmesser des Impflings 12 ist. Auf diese Weise kann der Impfling 12 in die Innenausnehmung am Austritt 10 des Tiegels hinein gefahren werden und auf diese Weise ein Verschluss gebildet werden.

Der Impfling 12 befindet sich am Impflinghalter 14 unterhalb des Austritts 10 des Tiegels 4. Die Kopplung des Imfplinghalters 14 mit dem Antriebssystem 16 erfolgt über eine Ziehwelle. Über das Antriebssystem 16 wird auf die Ziehwelle und somit auf den Impflingshalter eine Rotation aufgeprägt. Die Ziehwelle ist über eine nicht dargestellte Höhensteuereinrichtung höhenverstellbar.

Bei der erfindungsgemäßen Vorrichtung erfolgt eine Durchmesserregelung des Siliziumstabes und eine Temperaturregelung des Siliziums am Austritt 10 bzw. der Schmelze im Tiegel 4 wie bei herkömmlichen Einrichtungen, die nach dem Zonenziehverfahren arbeiten. Zusätzlich zu dieser Durchmesser- und Temperaturregelung wird bei der vorliegenden Erfindung bevorzugt, eine Differenzdruckregelung zwischen den Druckbereichen 1 und 2 sowie eine Schmelzniveauregelung der Schmelze im Tiegel 4 vorzunehmen. Nachfolgend erfolgt eine detailliertere Erläuterung der Schmelzniveauregelung. Bei der vorliegenden Erfindung arbeitet der Tiegel 4 als Pufferbehälter, in dem die Schmelzniveauhöhe über eine Differenzdruckregelung zwischen dem Druckbereich 1 und dem Druckbereich 2 vorgenommen wird, damit das Niveau der Schmelze im Tiegel 4 um ein festgelegtes Schmelzniveau pendeln kann. Durch die Schmelzniveauregelung ist es möglich, dass in dem Fall, in dem die Zuförderung von Siliziumpartikeln ins Stocken gerät, zwar das Schmelzniveau geringfügig absinken würde, jedoch der Schmelzfluss nicht abreißt. Der Schmelzfluss wird lediglich kleiner, wodurch sich kurzzeitig ein geringeres Kristallwachstum am Impfling 12 ergibt. Das geringere Kristallwachstum ist über eine langsamere Zielgeschwindigkeit ausgleichbar.

Wenn anschließend wieder ausreichend Silizium dem Tiegel 4 zugeführt wird, steigt das Niveau der Schmelze im Tiegel 4 an und pendelt sich der Schmelzfluss auf den gewünschten Wert ein. Im Ergebnis der Schmelzniveauregelung wirkt der Tiegel in Form eines Pufferbehälters als Dämpfungsglied für die Schmelzzone, so dass das Gesamtsystem bei Störung in der Zuförderung eine verbesserte Reaktion aufweist.

Dem Tiegel 4 wird in der Ausgestaltung entsprechen Figur 2A über eine Leitung 54 das teilchenförmige Silizium zugeführt. Da sich das Ende der Zuführleitung 54 an einem Abschnitt des Umfangs im kegelförmigen Tiegelabschnitt 50 befindet, liegen am Außenumfang der Schmelze im Tiegel 4 uneinheitlich aufgeschmolzene Partikel vor.

In einer Variante des ersten Ausführungsbeispiels, die in Figur 2B dargestellt ist, endet die Zuführleitung 56 ungefähr auf einer Achse zum Impfling 12. Zwischen dem Ende der Zuführleitung 56 und dem Tiegel 4 befindet sich eine Aufteileinrichtung 58, über die Siliziumpartikel aus dem Ende der Zuführleitung 56 an zumindest zwei Außenumfangsabschnitten der Schmelze im Tiegel 4 in den Tiegel 4 gelangen können. Dieses ist im Beispiel von Figur 2B in Form von zwei geneigten Abschnitten umgesetzt. Diese geneigten Abschnitte können beispielsweise rotationssymmetrisch um 360 ° vorgesehen sein. Mit der Aufteileinrichtung 58 in Figur 2B ist es möglich, ein gleichmäßigeres Aufschmelzen der Partikel im Tiegel 4 vorzunehmen. Ein weiterer Vorteil der Aufteileinrichtung besteht darin, dass die Abstrahlverluste der Schmelze verringert werden können.

In der in Fig. 2B gezeigten Ausgestaltung kann z.B. eine radiale Aussparung oder mehrere radiale Aussparungen in der Aufteileinrichtung vorgesehen sein, durch die eine optische Erfassung der Ausdehnung der Schmelze im Tiegel 4 möglich ist.

Alternativ dazu kann der Durchmesser der Aufteileinrichtung so gestaltet sein, dass die Schmelze von oben durch den Höhensignalsensor 42 optisch erfassbar ist.

Nachfolgend wird das Verbindungssystem 30 zwischen dem oberen Druckbereich 1 und dem unteren Druckbereich 2 detaillierter beschrieben. Die Funktion des Verbindungssystems 30 ergibt sich aus dem Umstand, dass, wenn der Tiegel 4 mit einer Siliziumschmelze gefüllt ist, eine Gasströmung zwischen dem oberen Druckbereich 1 und dem unteren Druckbereich 2 nicht mehr über den Austritt 10 des Tiegels 4 möglich ist. Über das Verbindungssystem 30 ist es möglich, die Drücke in den Druckbereichen 1 und 2 zu halten. Über das in Figur 1 gezeigte Steuerventil 26 ist dem unteren Druckbereich 2 das Inertgas in einer definierten Menge pro Zeiteinheit zuführbar. Das Gas strömt dann aus dem unteren Druckbereich 2 über das Verbindungssystem 30 in den oberen Druckbereich 1. Aus dem oberen Druckbereich 1 gelangt das Gas über das Steuerventil 36.

Das Verbindungssystem 30 weist in der Ausgestaltung entsprechend dem ersten Ausführungsbeispiel aus Figur 1 in Parallelschaltung eine Drosselblende 60, eine Differenzdruckregelventil 62 und eine Differenzdruckmesseinrichtung 64 auf. Die Differenzdruckmesseinrichtung 64 muss nicht notwendigerweise vorgesehen sein, da der Druck über der Drosselblende 60 zumindest in der Größenordnung auch aus den Messsignalen der Druckmesseinrichtungen 28 und 38 ermittelbar ist. Bei der Dimensionierung der Drosselblende 60 sind folgende Erwägungen hilfreich. Im geschlossenen Zustand des Druckregelventils 62 baut sich ein definierter Maximaldifferenzdruck zwischen den Druckbereichen 1 und 2 auf. Die Dimensionierung der Drosselblende ergibt sich nun aus der maximal zulässigen Höhe der Schmelze im Tiegel.

Wenn nun angenommen wird, dass das Differenzdruckregelventil in fehlerhafter Weise schließt, so würde ohne eine Drosselblende 60 keine Gasströmung in Richtung des oberen Druckbereiches 1 vorliegen. Im Ergebnis würde sich der Druck im unteren Druckbereich 2 erhöhen, während sich der Druck im oberen Druckbereich 1 abbauen würde. Im Ergebnis würde eine schnelle unkontrollierte Erhöhung des Differenzdrucks über dem Tiegel 4 vorliegen, was zu einem Überlaufen der Schmelze über den Tiegel 4 hinaus führen würde. Wenn beispielsweise die Tiegelhöhe 10 cm beträgt so würde ein Differenzdruck von 10 · 230 Pa = 2300 Pa zu einem Überlaufen der Schmelze führen (siehe die nachfolgende Herleitung). In diesem Fall wäre es günstig, wenn die Drosselblende 60 so dimensioniert würde, dass sich beim gegebenen Gasdurchfluss und bei geschlossenem Druckregelventil 62 ein maximaler Differenzdruck von 2000 Pa aufbaut. Im Ergebnis würde sich dann bei einem tatsächlichen Ausfall des Regelventils bzw. Steuerventils ein Differenzdruck von 2000 Pa aufbauen.

Nachfolgend werden nähere Betrachtungen zur Berechnung des Differenzdrucks angestellt.

Während des Ziehens durch den Impfling 12 erfolgt ein kontinuierlicher Schmelzfluss, der eine dynamische Druckdifferenz bewirkt, die dem statischen Druck entgegen wirkt. Daraus ergibt sich für den Differenzdruck, der über das Inertgas zu erzeugen ist, folgende Gleichung:

$$P_{diff} = P_{stat} - P_{dyn}.$$

Für den notwendigen Differenzdruck zwischen den Druckbereichen 1 und 2 ergibt sich zum Stützen der Schmelze im statischen Fall, das heißt bei stagnierendem Schmelzfluss, folgende Gleichung:

$$P_{stat} = h * p_{Silizium} * g.$$

Somit ist der statische Druck proportional zur Höhe der Schmelze und dem spezifischen Gewicht des Siliziums. Somit erzeugt Silizium pro 1 cm Höhe der Schmelze einen statischen Druck von 230 Pa ($N/m^2$), so dass sich bei einer Höhe der Schmelze von 5 cm ungefähr 1150 Pa ergeben.

Der dynamische Druckanteil ergibt sich aus der folgenden Gleichung:

$$P_{dyn} = v * 8 * \eta * h / R^2.$$

Um diesen dynamischen Druckanteil abschätzen zu können, wird folgende Annahme getroffen: $\eta = 1 * 10^{-3}$ Pa * s, der durchschnittlichen Viskosität von flüssigen Metallen an der Schmelztemperatur. Wird nun als Schmelzfluss $6,67 · 10^{-7} m^3 / s$ angesetzt (ergibt sich aus der Ziehgeschwindigkeit 2mm/min für einen Stab mit 150 mm Durchmesser), so ergibt sich bei einem angenommenen Austrittsquerschnitt aus dem Tiegel von 3 $cm^2$ eine Strömungsgeschwindigkeit $v = 2,2 * 10^{-3}$ m/s. Nimmt man ferner an, dass die hohlzylinderartige Öffnung des Tiegels für den dynamischen Druckabfall maßgeblich ist und nimmt man die Höhe dieses Abschnittes mit 2 cm an, dann lässt sich rechnerisch zeigen, dass der dynamische Druckanteil im Bereich von 3 mPa liegt, also weit unterhalb des statischen Druckes.

In der Praxis wird der dynamische Anteil dennoch höher sein, weil die aus dem Tiegel fließende Schmelze auf die Kristallisationszone trifft, die Viskosität der Schmelze sich also in diesem Bereich sehr schnell erhöht und auf diese Weise der Schmelzfluss gebremst wird.

Bei einer Gesamtbetrachtung des Differenzdrucks bei einer Annahme des Schmelzniveaus von 5 cm und bei einem Schmelzfluss von $6,67 · 10^{-7} m^3 / s$ ergäbe sich somit ein theoretischer Wert von maximal 1150 Pa, der in der Realität aufgrund der Viskositätserhöhung geringer sein wird.

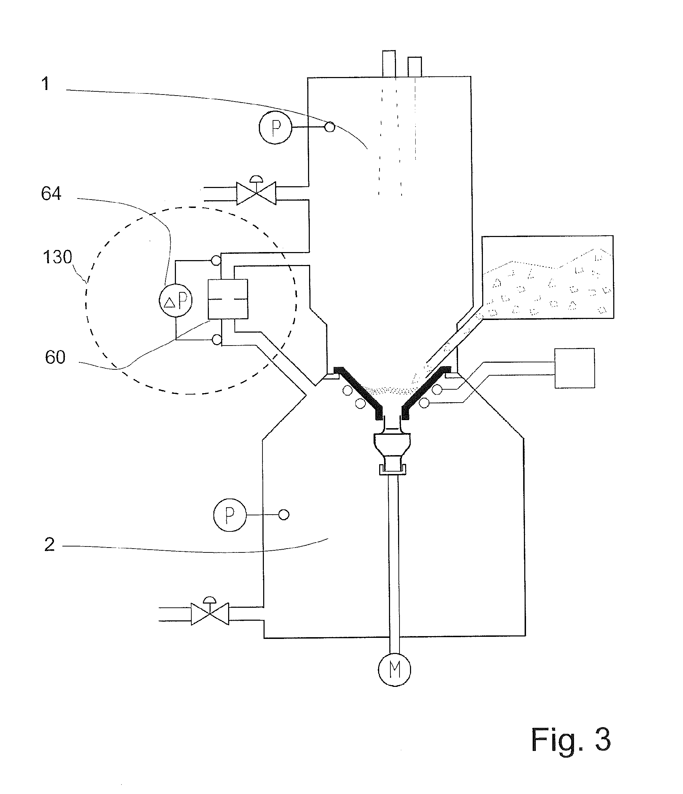

In Figur 3 ist eine erfindungsgemäße Vorrichtung entsprechend einem zweiten Ausführungsbeispiel gezeigt, die sich von der Vorrichtung des ersten Ausführungsbeispiels lediglich in der Ausgestaltung des Verbindungssystems 130 unterscheidet. Das Verbindungssystem 130 entsprechend dem zweiten Ausführungsbeispiel weist die Drosselblende 60 und die Differenzdruckmesseinrichtung 64 in Parallelschaltung auf. Das Differenzdruckregelventil 62 ist nicht vorgesehen. Aufgrund der vorstehenden Erwägungen zur Ausgestaltung der Drosselblende beim ersten Ausführungsbeispiel erfolgt nun die Differenzdruckregelung über einen variablen Inertgas Massenstrom. Von Vorteil ist dabei der verringerte vorrichtungstechnische Aufwand. Nachteilige Einflussgrößen sind jedoch hier, dass der Gasstrom nicht konstant gehalten werden kann und sich somit nachteilige prozessrelevante Einflüsse ergeben.

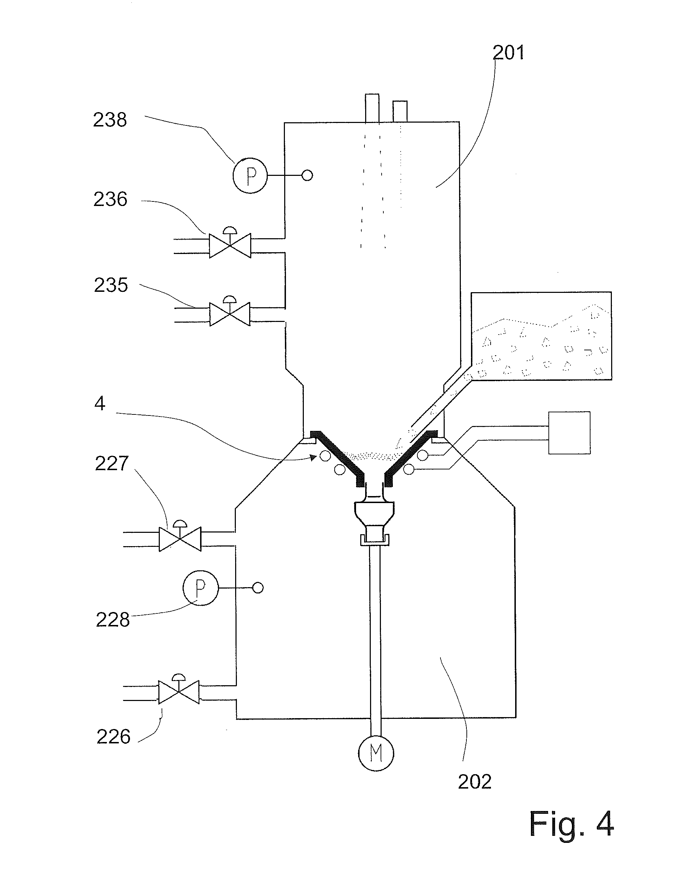

Die in Figur 4 gezeigte erfindungsgemäße Vorrichtung entsprechend dem dritten Ausführungsbeispiel unterscheidet sich von denen des ersten und zweiten Ausführungsbeispiels darin, dass kein Verbindungssystem zwischen den Druckbereichen 201 und 202 vorgesehen ist. Ansonsten entspricht die Ausgestaltung der Vorrichtung denen im ersten und zweiten Ausführungsbeispiel.

Statt des Verbindungssystems sind im dritten Ausführungsbeispiel zum unteren Druckbereich 202 hin ein Einlasssteuerventil 226 und ein Auslasssteuerventil 227 vorgesehen und sind zum oberen Druckbereich 201 hin ein Einlasssteuerventil 235 und ein Auslasssteuerventil 236 vorgesehen. Wie beim ersten und zweiten Ausführungsbeispiel sind Druckmesseinrichtungen 228, 238 beim dritten Ausführungsbeispiel vorgesehen. Die Einstellung der Höhe der Schmelze im Tiegel 4 beim dritten Ausführungsbeispiel erfolgt über eine Ansteuerung der Ventile 226, 227 und 235, 236 oder zumindest zwei von diesen. Dabei werden als Messgrößen die Ausgangsgrößen der Druckmesseinrichtungen 228, 238 verwendet.

Nachfolgend erfolgt eine beispielhafte Beschreibung des erfindungsgemäßen Verfahrens zur Herstellung von Material mit mono- oder multikristalliner Struktur am Beispiel des ersten Ausführungsbeispiels. Dieses Verfahren kann mit Anpassung an die Abwandlung im zweiten und dritten Ausführungsbeispiel entsprechend angewendet werden und ist nicht auf Silizium beschränkt, sondern kann entsprechend auch auf die vorstehend genannten anderen Materialien angewendet werden.

1. Beginn des Umschmelzvorgangs

Der Beginn des Umschmelzvorgangs beginnt mit einem Evakuieren der Anlage und einem anschließenden Fluten der Anlage mit dem Inertgas. Es erfolgt eine Einstellung eines definierten Massenstromes über das untere Steuerventil 26. Es erfolgt ein Einstellen des gewünschten Druckbereiches im Überdruckbereich über das Drucksteuerventil 38 am oberen Druckbereich. Das Differenzdruckregelventil 62 befindet sich dabei in der geschlossenen Stellung.

Anschließend wird die Ziehwelle mit dem montierten Impfling 12 so weit nach oben verfahren, bis dass der Impfling 12 den Austritt 10 des Tiegels 4 verschließt. Sollte sich aufgrund eines vorausgegangenen Ziehvorgangs noch Restsilizium im Tiegel 4 befinden, so wird der Impfling 12 manuell so weit in den Tiegel 4 herangefahren, dass eine Kollision mit dem Tiegel bzw. mit der im Tiegel befindlichen Restschmelze verhindert ist.

Anschließend wird über den Vorratsbehälter 6 ein teilweises Befüllen des Tiegels 4 vorgenommen, so dass sich ein Schmelzniveau im Tiegel 4 unter dem angestrebten Zielniveauwert erwarten lässt. Dabei erfolgt ein manuelles Steuern der Zuförderung des Siliziums über den Anlagenbediener. Das Aufheizen des Siliziums auf ca. 600 °C erfolgt über eine in Figur 1 nicht dargestellte Hilfswärmequelle. Diese Zwischentemperatur ist für ein elektromagnetisches Koppeln zwischen Induktionsheizung und Silizium notwendig. Nach dem Erreichen der Zwischentemperatur von ca. 600 °C oder einem vergleichbaren Wert für anderes Material, wird das Aufschmelzen über die Induktionsheizung vermittels der zugehörigen Induktionsspule 18 fortgesetzt, wobei die Temperaturregelung über den als Pyrometer ausgebildeten Temperatursignalsensor 44 erfolgt.

Nach Erreichen der Schmelztemperatur, das heißt für den Fall von Silizium 1430 °C, und bei abgeschlossenem Aufschmelzen bildet sich aufgrund der Siliziumschmelze ein gasdichter Pfropfen im Tiegel 4. Dieser Zustand lässt sich einerseits dadurch erkennen, dass der Anlagenbediener diesen Zustand wahrnimmt, oder er lässt sich aufgrund des Bildverarbeitungssystems und des Pyrometers schlussfolgern.

Alternativ dazu kann dieser Zustand auch über die Differenzdruckmessung über das Erkennen eines gewissen Druckanstiegs wahrnehmen, da der Gesamtströmungswiderstand zwischen den beiden Druckbereichen 1 und 2 zunimmt.

Wenn der Prozesszustand der Ausbildung eines gasdichten Pfropfens erkannt wird, werden die Differenzdruck- und Schmelzniveauregelung aktiviert. Es erfolgt ein automatisches Nachfördern von weiterem Silizium, bis dass die Sollschmelzhöhe im Tiegel 4 erreicht ist. Diese Sollschmelzhöhe wird über die Aufnahmeeinrichtung 42 und das Bildverarbeitungssystem erfasst. Der Differenzdruck muss der Bedingung $P_{stat} = h * P_{Silizium} * g$ genügen.

Es erfolgt ein Anschmelzen des Impflings 12 im Zuge des Aufschmelzvorgangs, der Konus wird durch den Anlagenbediener manuell auf den Zieldurchmesser des Siliziumstabes gezogen. Wenn der gewünschte Zieldurchmesser erreicht ist, erfolgt ein automatisches Fortsetzen des Ziehvorgangs.

Während des Ziehvorgangs des Stabes ist die Durchmesser- und Temperaturregelung aktiv. Es erfolgt eine Regelung von Differenzdruck und Schmelzniveau im Tiegel 4 auf konstante Sollwerte.

Damit eine gewünschte Ziellänge erreicht wird, muss der Vorratsbehälter ausreichend Siliziumpartikel bevorraten. Der Hintergrund ist, dass ein Nachfüllen des Behälters während des Betriebes eine unerwünschte Prozessstörung wäre, aus der sich eine mögliche Unterbrechung des Schmelzflusses ergeben könnte.

Der Ziehvorgang wird beendet, wenn der Stab am Impfling 12 eine gewünschte Länge erreicht hat. Nun erfolgt ein manuelles Verjüngen des Durchmessers des Siliziumstabes durch Erhöhen der Vorschubgeschwindigkeit des Antriebssystems 16. Nach dem Beendigen des Ziehens des Konus wird die Partikelzufuhr über die Fördereinrichtung 8 gestoppt. Es erfolgt eine Druckerhöhung im unteren Druckbereich 2 sowie ein Zurückregeln der Heizung durch die Induktionsspule 18. Anschließend erstarrt das im Tiegel verbleibende Silizium und es bildet sich ein Verschlusspfropfen im Tiegel aus.

Mit diesem erfindungsgemäßen Verfahren, das nur beispielhaft für die Erzeugung von monokristallinem Silizium vorstehend beschrieben wurde, lässt sich monokristallines Silizium mit hoher Reinheit herstellen. Das vorstehende Verfahren lasst sich auch auf die Herstellung anderer vorstehend genannten Materialien anwenden.

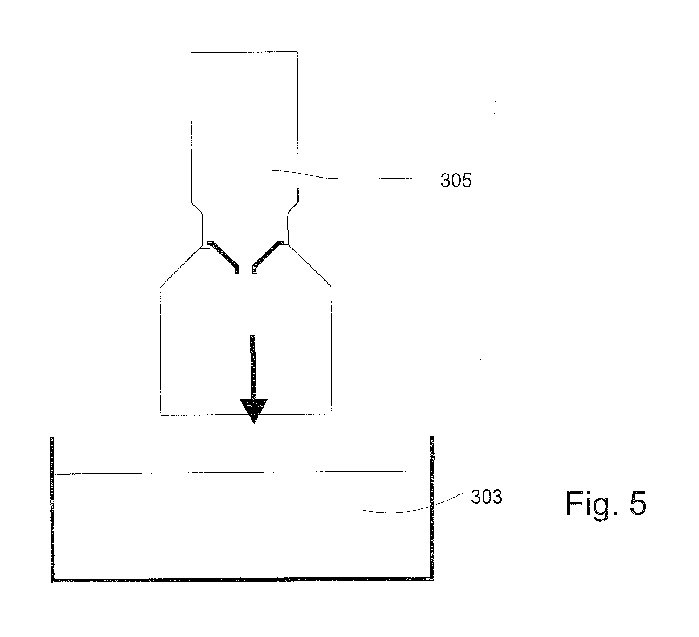

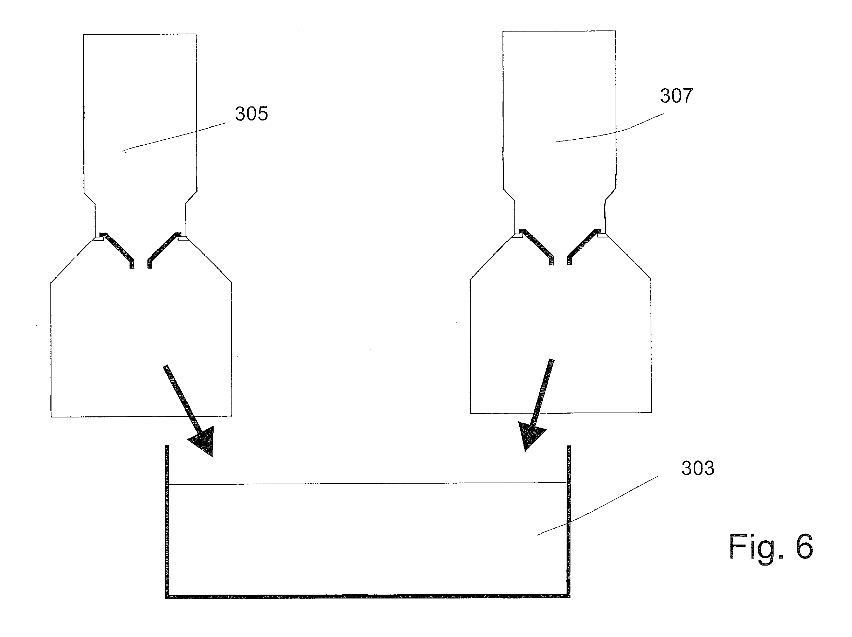

In den Figuren 5 und 6 sind eine Vorrichtung und ein Verfahren entsprechend einem vierten und fünften Ausführungsbeispiel gezeigt. Gemeinsam ist diesen Ausführungsbeispielen, dass der Ort, an dem der Impfling aus dem Behältnis gezogen wird, nicht der Tiegel ist, über dem die Druckdifferenz herrscht, sondern ein Behältnis 303, in das die Schmelze gefördert wird, nachdem diese den Tiegel 4 verlassen hat. Der Vorteil einer derartigen Ausgestaltung liegt darin, dass das Behältnis 303 ein großes Volumen haben kann und der Impfling in dieses entgegen der Richtung der Wirkung Schwerkaft eingebracht werden kann. Auf diese Weise sind nicht nur Durchmesser von beispielhaft 150 oder 200 mm erreichbar, die beim Zonenziehen vorteilhaft sind, sondern können die beim Tiegelziehen erreichten Durchmesser von beispielhaft 300 mm oder sogar 450 mm erreicht werden. Da das Behältnis 303 kein Durchlauftiegel sein muss, lassen sich mit diesem auch Massen von z.B. 1t aufnehmen. Somit hat der Tiegel 4 in dem fünften und sechsten Ausführungsbeispiel die Funktion des Aufschmelzens.

Erfindungsgemäß werden eine Vorrichtung und ein Verfahren zur Herstellung von Materialen mit mono- oder multikristalliner Struktur vorgesehen, bei denen ein Behältnis zwischen zwei Druckbereichen angeordnet ist und über eine Einstellung des Differenzdrucks zwischen den Druckbereichen eine Einstellung der Höhe der Schmelze im Behältnis erfolgt. Im Ergebnis kann auch teilchenförmiges Material dem Behältnis kontinuierlich zugeführt und gleichmäßig aufgeschmolzen werden. Auch lässt sich aus dem Behältnis Ausgabematerial mit hoher Reinheit abziehen.

Bezugszeichenliste

| | |
|---|---|
| 1 | Druckbereich |
| 2 | Druckbereich |
| 4 | Tiegel |
| 6 | Vorratsbehälter |
| 8 | Fördereinrichtung |
| 10 | Austritt |
| 12 | Impfling |
| 14 | Impflinghalter |
| 16 | Antriebssystem |
| 18 | Induktionsspule |
| 20 | Erwärmungseinrichtung |
| 22 | unterer Druckbehälter |
| 24 | Einlass |
| 26 | Steuerventil |
| 28 | Druckmesseinrichtung |
| 30 | Verbindungssystem |
| 32 | oberer Druckbehälter |
| 34 | Auslass |
| 36 | Steuerventil |
| 38 | Druckmesseinrichtung |
| 40 | Steuereinrichtung |
| 42 | Höhensignalsensor / Bildaufnahmeeinrichtung |
| 44 | Temperatursignalsensor |
| 46 | Flanschabschnitt |
| 48 | Trenneinrichtung |
| 50 | kegelförmiger Tiegelabschnitt |
| 54 | Zuführleitung |
| 56 | Zuführleitung |
| 58 | Aufteileinrichtung |
| 60 | Drosselblende |
| 62 | Differenzdruckregelventil |
| 64 | Differenzdruckmesseinrichtung |
| 130 | Verbindungssystem |
| 201 | Druckbereich |
| 202 | Druckbereich |
| 226 | Einlasssteuerventil |
| 227 | Auslasssteuerventil |
| 235 | Einlasssteuerventil |
| 236 | Auslasssteuerventil |
| 228 | Druckmesseinrichtung |
| 238 | Druckmesseinrichtung |
| 303 | Behälter |
| 305 | erste Aufschmelzvorrichtung |
| 307 | zweite Aufschmelzvorrichtung |

Patentansprüche

1. Verfahren zur Herstellung von Material mit mono- oder multikristalliner Struktur mit den Schritten

a) Einbringen eines teilchenförmigen Materialgemisches in einen Einlass eines als Tiegel ausgestalteten Behältnisses (4),
b) Erwärmen des Materialgemisches in einer Schmelzzone, des Behältnisses (4) mit einer Induktionsspule (18), um eine Schmelze des Materialgemisches vorzusehen,
wobei das Behältnis (4) kegelförmig ausgebildet ist, um ein Nachfließen der Schmelze des Materialgemischs zu einem Auslass (10) des Behältnisses (4) hin sicherzustellen und wobei die Induktionsspule (18) außerhalb des Behältnisses (4) und dieses im kegelförmigen Behältnisabschnitt (50) im Wesentlichen ringförmig umgebend angeordnet ist, wobei das Materialgemisch in der Schmelzzone des Behältnisses (4) über eine Druckdifferenz zwischen dem Einlass und dem Auslass (10) des Behältnisses (4) statisch gestützt wird, wobei die Druckdifferenz proportional zur Höhe der Schmelze ist, wobei das statische Stützen zwischen zwei Kammern (1, 2) erfolgt, die durch das Behältnis (4) getrennt sind und zwischen denen die Druckdifferenz vorliegt, wobei entweder jeder der Kammern vom Druck her getrennt geregelt wird oder diese Kammern durch eine Druckdifferenzregelung miteinander verbunden sind.

2. Verfahren nach Anspruch 1, das ferner nach Schritt b) den Schritt aufweist:

   c) Kontaktieren des Materialgemischs, vorzugsweise in der Schmelzzone, mit einem Impfling (12), vorzugsweise einem Impfkristall, am oder benachbart zum Auslass (10) des Behältnisses(4).

3. Verfahren nach Anspruch 2, das ferner nach Schritt c) den Schritt aufweist:

   d) Abziehen des Impfkristalls aus der Schmelzzone zum Ausbilden eines monokristallinen, halbleitenden Siliziumstabes.

4. Vorrichtung zur Herstellung von Material mit mono- oder multikristalliner Struktur mit einem als Tiegel ausgebildeten Behältnis (4), das einen Einlass hat, über den ein teilchenförmiges Materialgemisch einbringbar ist, und das kegelförmig ausgebildet ist, um ein Nachfließen einer Schmelze des Materialgemischs zu einem Auslass (10) des Behältnisses (4) hin sicherzustellen, einer Erwärmungseinrichtung (18), mit der das Materialgemisch in einer Schmelzzone des Behältnisses (4) vermittels einer Induktionsspule (18), die außerhalb des Behältnisses (4) und dieses im kegelförmigen Behältnisabschnitt (50) im Wesentlichen ringförmig umgebend angeordnet ist, erwärmbar ist, um eine Schmelze des Materialgemisches vorzusehen, einer Druckerzeugungseinrichtung (26, 30, 36) zum Erzeugen einer Druckdifferenz zwischen dem Einlass und dem Auslass (10) des Behältnisses (4), über die das Materialgemisch in der Schmelzzone des Behältnisses (4) statisch stützbar ist, wobei die Druckdifferenz proportional zur Höhe der Schmelze ist, wobei das statische Stützen zwischen zwei Kammern (1, 2) erfolgt, die durch das Behältnis (4) getrennt sind und zwischen denen die Druckdifferenz vorliegt, wobei entweder Jeder der Kammern vom Druck her getrennt geregelt wird oder diese Kammern durch eine Druckdifferenzregelung miteinander verbunden sind.

5. Vorrichtung nach Anspruch 4 mit einem Impfling, über den das Materialgemisch in Form von Halbleitermaterial, vorzugsweise in der Schmelzzone, an oder benachbart zu einem Auslass (10) des Behältnisses kontaktierbar ist und über den Halbleitermaterial aus der Schmelzzone abziehbar ist

6. Vorrichtung nach Anspruch 4, wobei das Material ein halbleitendes Material, ein Verbindungshalbleiter und/oder eine Metall-Legierung ist

7. Vorrichtung nach einem der Ansprüche 4 bis 6, wobei die Messung des Volumen des Materials im Behältnis über eine Durchmessermessung des Materials im Behältnis erfolgt, so dass eine Bildaufnahmeeinrichtung zur Volumenmessung einsetzbar ist.

## Claims

1. A method for producing material having a monocrystalline and multicrystalline structure, with the steps

   a) introduction of a particulate material mixture into an inlet of a container (4) configured as a crucible,
   b) heating of the material mixture in a melting zone of the container (4) by means of an induction coil (18), in order to provide a melt of the material mixture,

   the container (4) being designed conically in order to ensure a subsequent flow of the melt of the material mixture toward an outlet (10) of the container (4), and the induction coil (18) being arranged outside the container (4) and serving to surround the latter essentially in the form of a ring in the conical container portion (50), the material mixture in the melting zone of the container (4) being supported statically via a pressure difference between the inlet and the outlet (10) of the container (4), the pressure difference being proportional to the height of the melt, the static support taking place between two chambers (1, 2) which are separated by the container (4) and between which the pressure difference prevails, with either each of the chambers being regulated separately in terms of pressure or these chambers being connected to one another by regulation of the pressure difference.

2. The method as claimed in claim 1, which has furthermore, after step b), the step:

   c) contacting of the material mixture, preferably in the melting zone, with an inoculant (12), preferably an inoculating crystal, at or adjacent to the outlet (10) of the container (4).

3. The method as claimed in claim 2, which has furthermore, after step c), the step:

   d) pulling the inoculating crystal out of the melting zone in order to form a monocrystalline semiconducting silicon rod.

4. A device for producing material having a monocrystalline or multicrystalline structure, with a container (4) which is designed as a crucible and has an inlet, via which a particulate material mixture can be introduced, and which is designed conically, in order to ensure a subsequent flow of a melt of the material mixture toward an outlet (10) of the container (4), a heating arrangement (18), by means of which the material mixture can be heated in a melting zone of the container (4) by means of an induction coil (18), which is arranged outside the container (4) and serves to surround the latter essentially in the form of a ring in the conical container portion (50), in order to provide a melt of the material mixture, a pressure generation arrangement (26, 30, 36) for generating a pressure difference between the inlet and the outlet (10) of the container (4), via which pressure difference the material mixture can be supported statically in the melting zone of the container (4), the pressure difference being proportional to the height of the melt, the static support taking place between two chambers (1, 2) which are separated by the container (4) and between which the pressure difference prevails, with either each of the chambers being regulated separately in terms of pressure or these chambers being connected to one another by the regulation of pressure difference.

5. The device as claimed in claim 4, with an inoculant, via which the material mixture in the form of semiconductor material, preferably in the melting zone, can be contacted at or adjacent to an outlet (10) of the container and via which semiconductor material can be pulled out of the melting zone.

6. The device as claimed in claim 4, the material being a semiconducting material, a connecting semiconductor, and/or a metal alloy.

7. The device as claimed in one of claims 4 to 6, the measurement of the volume of the material in the container taking place via the measurement of the diameter of the material in the container, so that a camera arrangement can be used for the volume measurement.

## Revendications

1. Procédé de production de matériau à structure monocristalline ou polycristalline, comprenant les étapes suivantes :

   a) introduction d'un mélange de matériau particulaire par une admission d'un récipient (4) réalisé comme creuset,
   b) chauffage du mélange de matériau par une bobine d'induction (18) dans une zone de fusion du récipient (4) pour prévoir une fonte du mélange de matériau,

   le récipient (4) étant prévu de forme conique pour permettre un écoulement de la fonte du mélange de matériau vers une évacuation (10) du récipient (4), et la bobine d'induction (18) étant disposée à l'extérieur du récipient (4) et entourant celui-ci sensiblement en forme d'anneau sur la section conique de récipient (50), le mélange de matériau étant soutenu statiquement dans la zone de fusion du récipient (4) grâce à un différentiel de pression entre l'admission et l'évacuation (10) du récipient (4), le différentiel de pression étant proportionnel à la hauteur de la fonte, le soutien statique étant réalisé entre deux compartiments (1, 2) séparés par le récipient (4) et entre lesquels est présenté le différentiel de pression, la pression de chacun des compartiments étant régulée séparément, ou bien lesdits compartiments étant reliés l'un à l'autre par une régulation de différentiel de pression.

2. Procédé selon la revendication 1, comprenant en outre l'étape suivante après l'étape b) :

   c) mise en contact du mélange de matériau, préférentiellement dans la zone de fusion, avec un germe (12), préférentiellement un germe cristallin, contre l'évacuation (10) du récipient (4) ou à proximité de celle-ci.

3. Procédé selon la revendication 2, comprenant en outre l'étape suivante après l'étape c) :

   d) retrait du germe cristallin de la zone de fusion afin de former un lingot de silicium monocristallin semi-conducteur.

4. Dispositif de production de matériau à structure monocristalline ou polycristalline, avec un récipient (4) réalisé comme creuset, présentant une l'admission par laquelle un mélange de matériau particulaire peut être introduit, et prévu de forme conique pour permettre un écoulement d'une fonte du mélange de matériau vers une évacuation (10) du récipient (4), un dispositif de chauffage (18) permettant de chauffer le mélange de matériau dans une zone de fusion du récipient (4) au moyen d'une bobine d'induction (18) disposée à l'extérieur du récipient (4) et entourant celui-ci sensiblement en forme d'anneau sur la section conique de récipient (50), afin de prévoir une fonte du mélange de matériau,

un dispositif générateur de pression (26, 30, 36) permettant de générer un différentiel de pression entre l'admission et l'évacuation (10) du récipient (4), au moyen duquel le mélange de matériau est soutenu statiquement dans la zone de fusion du récipient (4), le différentiel de pression étant proportionnel à la hauteur de la fonte, le soutien statique étant réalisé entre deux compartiments (1, 2) séparés par le récipient (4) et entre lesquels est présenté le différentiel de pression, la pression de chacun des compartiments étant régulée séparément, ou bien lesdits compartiments étant reliés l'un à l'autre par une régulation de différentiel de pression.

5.   Dispositif selon la revendication 4, avec un germe au moyen duquel le mélange de matériau sous la forme de matériau semi-conducteur peut être mis en contact, préférentiellement dans la zone de fusion, contre une évacuation (10) du récipient ou à proximité de celle-ci, et au moyen duquel le matériau semi-conducteur peut être retiré de la zone de fusion.

6.   Dispositif selon la revendication 4, où le matériau est un matériau semi-conducteur, un semi-conducteur composite et/ou un alliage métallique.

7.   Dispositif selon l'une des revendications 4 à 6, où la mesure de volume du matériau dans le récipient est effectuée par mesure de diamètre du matériau dans le récipient, de manière à permettre l'insertion d'un dispositif d'enregistrement d'image pour la mesure de volume.

Fig. 1

Fig. 2A

Fig. 2B

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4216519 A1
- EP 0634504 A1
- JP 62246894 A
- DE 1204837 B
- US 4108714 A
- FR 1387497 A